(19) Europäisches Patentamt
European Patent Office
Office européen des brevets

(11) **EP 4 779 662 A1**

(12) **EUROPEAN PATENT APPLICATION**
published in accordance with Art. 153(4) EPC

(43) Date of publication:
**22.07.2026 Bulletin 2026/30**

(51) International Patent Classification (IPC):
***H01F 27/28*** (2006.01)      ***H01L 23/64*** (2006.01)

(21) Application number: **23953321.9**

(52) Cooperative Patent Classification (CPC):
**H01F 27/28; H10W 44/00**

(22) Date of filing: **25.09.2023**

(86) International application number:
**PCT/CN2023/121129**

(87) International publication number:
**WO 2025/065156 (03.04.2025 Gazette 2025/14)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **HUAWEI TECHNOLOGIES CO., LTD.
Shenzhen 518129 (CN)**

(72) Inventors:
• **YANG, Fangxu**
  **Shenzhen, Guangdong 518129 (CN)**
• **XU, Lingqun**
  **Shenzhen, Guangdong 518129 (CN)**
• **SHI, Lin**
  **Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(54) **ELECTRONIC DEVICE AND ELECTRONIC APPARATUS**

(57) This application provides an electronic component and an electronic device, and relates to the field of single-ended signal transmission, to reduce crosstalk between single-ended signals. The electronic component includes a first transmission wire, a second transmission wire, a first coil, and a second coil. The first coil is coupled to the first transmission wire, and the second coil is coupled to the second transmission wire. The first coil includes at least two turns of windings distributed at different layers, and the second coil includes at least one turn of winding. In addition, the at least two turns of windings in the first coil and the at least one turn of winding in the second coil are alternately disposed in a thickness direction (namely, a direction Z) of the electronic component and are inductively coupled (inductive couple) to each other.

FIG. 3

## Description

## TECHNICAL FIELD

This application relates to the field of single-ended signal transmission, and in particular, to an electronic component and an electronic device.

## BACKGROUND

In the field of high-speed parallel interfaces, such as a DDR (double data rate, DDR) field and an LPDDR (low power double data rate, LPDDR) field, crosstalk between single-ended signals has become a key factor that limits further improvement of system performance. To reduce crosstalk between single-ended signals of a parallel interface, an existing solution is to add more solder balls (balls) by using a chip package (package, PKG) and correspondingly add ground plated through holes (plated through holes, PTHs) in a printed circuit board (printed circuit board, PCB) for isolation. This increases a chip package size and PCB layout space, and further decreases competitiveness of a chip and a related system.

## SUMMARY

This application provides an electronic component and an electronic device, to reduce crosstalk between single-ended signals while achieving miniaturization of the electronic component.

This application provides an electronic component. The electronic component includes a first transmission wire, a second transmission wire, a first coil, and a second coil. The first coil is coupled to the first transmission wire, and the second coil is coupled to the second transmission wire. The first coil includes a plurality of turns of windings distributed at different layers, and the second coil includes at least one turn of winding. In addition, the plurality of turns of windings in the first coil and a plurality of turns of windings in the second coil are alternately disposed in a thickness direction of the electronic component, and are inductively coupled (inductive couple) to each other, that is, generate mutual inductance. In this case, flow directions of currents on the first coil and the second coil are set to be opposite, so that reverse inductive coupling can be formed between the first coil and the second coil, to reduce or eliminate mutual inductance between the first transmission wire and the second transmission wire, and further reduce crosstalk between signals on the first transmission wire and the second transmission wire.

In addition, based on a multi-layer coupled inductor design in this application, crosstalk between single-ended signals is reduced in a mutual inductance manner. This is more conducive to a high-speed and high-bandwidth scenario.

In some possible implementations, a projection of the plurality of turns of windings in the first coil at least partially overlaps a projection of the at least one turn of winding in the second coil, to ensure that clear mutual inductance and mutual capacitance can be generated between two adjacent turns of windings.

In some possible implementations, the electronic component includes a plurality of routing layers and a dielectric layer disposed between two adjacent routing layers. In this case, the plurality of turns of windings in the first coil and the at least one turn of winding in the second coil may be distributed at the plurality of routing layers.

In some possible implementations, the projection of the plurality of turns of windings in the first coil at least partially overlaps the projection of the at least one turn of winding in the second coil, to ensure that clear mutual inductance and mutual capacitance can be generated between two adjacent turns of windings.

In some possible implementations, the first coil includes two turns of windings distributed at different layers, and the second coil includes one turn of winding.

In some possible implementations, the first coil includes two turns of windings distributed at different layers, and the second coil includes two turns of windings distributed at different layers.

In some possible implementations, the first coil further includes a plurality of first metal vias, and two adjacent turns of windings in the first coil are connected through at least one first metal via.

In some possible implementations, the first coil further includes a plurality of first connection portions. One first connection portion is disposed between two adjacent turns of windings in the first coil, and the two adjacent turns of windings in the first coil each are connected to two ends of the first connection portion through different first metal vias.

In some possible implementations, the first connection portion and one turn of winding in the second coil are distributed at a same layer, so that a process can be simplified, manufacturing costs can be reduced, and a thickness of a package substrate can be reduced.

In some possible implementations, the second coil further includes a plurality of second metal vias, and two adjacent turns of windings in the second coil are connected through at least one second metal via.

In some possible implementations, the second coil further includes a plurality of second connection portions. One second connection portion is disposed between two adjacent turns of windings in the second coil, and the two adjacent turns of windings in the second coil each are connected to two ends of the second connection portion through different second metal vias.

In some possible implementations, the second connection portion and one turn of winding in the first coil are distributed at a same layer, so that a process can be simplified, manufacturing costs can be reduced, and a thickness of a package substrate can be reduced.

In some possible implementations, a transmission signal on the first transmission wire and a transmission signal on the second transmission wire are single-ended signals.

In some possible implementations, the plurality of turns of windings in the first coil are defected strip lines or defected microstrip lines (namely, defected microstrip structures, DMSs), and a defect (or a slot) is disposed on a side edge of the winding, to introduce a slow wave structure (slow wave structure), thereby reducing a layer deviation between the plurality of turns of windings and reducing space occupied by the coil.

In some possible implementations, the at least one turn of winding in the second coil is a defected strip line or a defected microstrip line (DMS), and a defect (or a slot) is disposed on a side edge of the winding, to introduce a slow wave structure (slow wave structure), thereby reducing a layer deviation between the plurality of turns of windings and reducing space occupied by the coil.

In some possible implementations, the electronic component may further include a third transmission wire and a third coil. The third coil is coupled to the third transmission wire. The third coil includes a plurality of turns of windings distributed at different layers. The plurality of turns of windings in the third coil and the at least one turn of winding in the second coil are alternately disposed in the thickness direction of the electronic component and are inductively coupled (inductive couple) to each other.

In some possible implementations, a projection of the plurality of turns of windings in the third coil at least partially overlaps the projection of the at least one turn of winding in the second coil.

In some possible implementations, a plurality of connection structures are disposed on an active surface of the electronic component, and the plurality of connection structures include a first connection structure, a second connection structure, and a third connection structure. The second connection structure is disposed adjacent to both the first connection structure and the third connection structure. The first transmission wire is connected to the first connection structure through the first coil, the second transmission wire is connected to the second connection structure through the second coil, and the third transmission wire is connected to the third connection structure through the third coil.

In some possible implementations, the first connection structure, the second connection structure, and the third connection structure are arranged in a straight-line shape.

In some possible implementations, the first connection structure, the second connection structure, and the third connection structure are arranged in a Z shape.

In some possible implementations, the first connection structure, the second connection structure, and the third connection structure are arranged in a fold-line shape.

This application further provides an electronic component. The electronic component includes a first transmission wire, a second transmission wire, a first coil, and a second coil. The first coil is coupled to the first transmission wire, and the second coil is coupled to the second output wire. The first coil includes at least one turn of transverse coil distributed at different layers. The second coil includes at least one turn of vertical coil, and the vertical coil is wound around the transverse coil. In this way, inductive coupling (inductive couple), namely, mutual inductance, can be generated between transverse inductance formed in the first coil and vertical inductance formed in the second coil. In this case, flow directions of currents on the first coil and the second coil are set, so that a flow direction of an induced current that is of the transverse inductance in the first coil and that is on the second coil can be opposite to a flow direction of a current on the second coil, and similarly, a flow direction of an induced current that is of the vertical inductance in the second coil and that is on the first coil is opposite to a flow direction of a current on the first coil, so that reverse inductive coupling is formed between the first coil and the second coil, to reduce or eliminate mutual inductance between the first transmission wire and the second transmission wire, and further reduce crosstalk between signals on the transmission wires.

In some possible implementations, the first coil includes a plurality of turns of transverse coils distributed at different layers, and the second coil includes a plurality of turns of vertical coils.

In some possible implementations, the second coil includes a plurality of upper-layer wires, a plurality of lower-layer wires, and a plurality of first metal vias. The plurality of upper-layer wires are disposed above the first coil, and the plurality of lower-layer wires are disposed below the first coil. Heads and tails of the plurality of upper-layer wires and the plurality of lower-layer wires are sequentially connected through the plurality of first metal vias to form the plurality of turns of vertical coils.

In some possible implementations, the electronic component includes a plurality of routing layers and a dielectric layer disposed between two adjacent routing layers. The plurality of upper-layer wires, the plurality of lower-layer wires, and the transverse coils are distributed at the plurality of routing layers.

In some possible implementations, the plurality of upper-layer wires are located at a same layer, and the plurality of lower-layer wires are located at a same layer. In other words, the plurality of upper-layer wires are manufactured by using a same process, and the plurality of lower-layer wires are manufactured by using a same process, so that a process can be simplified, manufacturing costs can be reduced, and a thickness of a package substrate can be reduced.

In some possible implementations, the plurality of upper-layer wires are disposed in parallel, and the plurality of lower-layer wires are disposed in parallel, to reduce space occupied by the second coil.

In some possible implementations, the first coil further includes a plurality of second metal vias, and two adjacent turns of windings in the first coil are connected through at least one second metal via.

In some possible implementations, the first coil further includes a plurality of connection portions. One connection portion is disposed between two adjacent turns of windings in the first coil, and the two adjacent turns of windings each are connected to two ends of the connection portion through different first metal vias.

This application further provides a circuit board, and the circuit board includes the electronic component provided in any one of the foregoing possible implementations.

This application further provides a chip, and the chip includes the electronic component provided in any one of the foregoing possible implementations.

This application further provides an electronic device. The electronic device includes a first electronic component and a second electronic component that are interconnected. The first electronic component is the electronic component provided in any one of the foregoing possible implementations; and the second electronic component is electrically connected to the first transmission wire and the second transmission wire in the first electronic component.

**BRIEF DESCRIPTION OF DRAWINGS**

FIG. 1 is a differential equivalent circuit diagram of two lossless coupled transmission wires;
FIG. 2 is a diagram of a structure of an electronic device according to an embodiment of this application;
FIG. 3 is a three-dimensional diagram of a multi-layer coupled inductor in a package substrate according to an embodiment of this application;
FIG. 4 is a side view of FIG. 3;
FIG. 5 is a top view of FIG. 3;
FIG. 6 is a diagram of a structure of a set of multi-layer mutual inductance coils according to an embodiment of this application;
FIG. 7 is a diagram of distribution of a plurality of coils according to an embodiment of this application;
FIG. 8 is a diagram of an arrangement of a plurality of solder balls according to an embodiment of this application;
FIG. 9 is a diagram of an arrangement of a plurality of solder balls according to an embodiment of this application;
FIG. 10 is a diagram of distribution of a plurality of coils according to an embodiment of this application;
FIG. 11 is a diagram of an arrangement of a plurality of solder balls according to an embodiment of this application;
FIG. 12 is a diagram of distribution of a plurality of coils according to an embodiment of this application;
FIG. 13 is a diagram of an arrangement of a plurality of solder balls according to an embodiment of this application;
FIG. 14 is a diagram of an arrangement of a plurality of solder balls according to an embodiment of this application;
FIG. 15 is a diagram of a structure of a winding according to an embodiment of this application;
FIG. 16 is a diagram of a structure of a winding according to an embodiment of this application;
FIG. 17 is a diagram of a structure of a winding according to an embodiment of this application;
FIG. 18 is a diagram of a structure of a winding according to an embodiment of this application;
FIG. 19 shows crosstalk curves of an electronic component in the conventional technology and this application;
FIG. 20 shows step response crosstalk curves of an electronic component in the conventional technology and this application;
FIGS. 21A and 21B are eye diagrams in the conventional technology and this application;
FIG. 22 is a diagram of a structure of a set of multi-layer mutual inductance coils according to an embodiment of this application; and
FIG. 23 is a cross-sectional view of FIG. 22 along OO' positions.

**DESCRIPTION OF EMBODIMENTS**

To make objectives, technical solutions, and advantages of this application clearer, the following clearly and completely describes the technical solutions in this application with reference to accompanying drawings in this application. It is clear that the described embodiments are a part rather than all of embodiments of this application. All other embodiments obtained by a person of ordinary skill in the art based on embodiments of this application without creative efforts shall fall within the protection scope of this application.

In the specification, embodiments, claims, and accompanying drawings of this application, terms "first", "second", and the like are merely intended for distinguishing and description, and shall not be understood as indicating or implying relative importance, or indicating or implying a sequence. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. "At least one (item)" means one or more, and "a plurality of' means two or more. "Mounting", "connection", "interconnection", and the like should be understood in a broad sense, for example, may be an electrical connection or a mechanical connection; may be a fixed connection, a detachable connection, or an integrated connection; or may be a direct connection, an indirect connection through an intermediate medium, or communication between interiors of two elements. In addition, terms "include", "have", or any variant thereof are intended to cover non-exclusive inclusion, for example, include a series of steps or units. A method, system, product, or device is not necessarily limited to those steps or units expressly listed, but may include other steps or units not expressly listed or inherent to such a process, method, product, or device. "Upper", "lower", "left", "right", and the like are used only relative to orientation of components in the accompanying drawings. These directional terms are relative concepts, are used for relative descriptions and clarifications, and may change accordingly as positions at which the components in the accompanying drawings are placed change.

Single-ended signals are referenced to the ground. Only one wire is required to transmit the signals, and one reference wire, namely, a ground wire, is required. Using the single-ended signals has an advantage of low costs, but also has a problem of poor interference resistance.

In an electronic component, between two single-ended signal transmission wires (or channels), a signal on one transmission wire (an attack wire) causes undesired impact on the other transmission wire (a victim wire), thereby causing crosstalk. The crosstalk may be caused by electromagnetic field coupling between the two transmission wires, and may be usually represented by mutual capacitance and mutual inductance.

A ratio of voltage noise measured at a near end of the victim wire to an incident excitation voltage on the attack wire is referred to as near-end crosstalk (near-end crosstalk, NEXT). A ratio of voltage noise at a far end of the victim wire to the incident excitation voltage on the attack wire is referred to as far-end crosstalk (far-end crosstalk, FEXT). The near-end crosstalk (NEXT) and the far-end crosstalk (FEXT) are two important types of crosstalk in total channel crosstalk. A problem of far-end crosstalk (FEXT) is more severe, and has become a key factor that restricts performance improvement of the component.

The following briefly describes far-end crosstalk (FEXT) between single-ended signals.

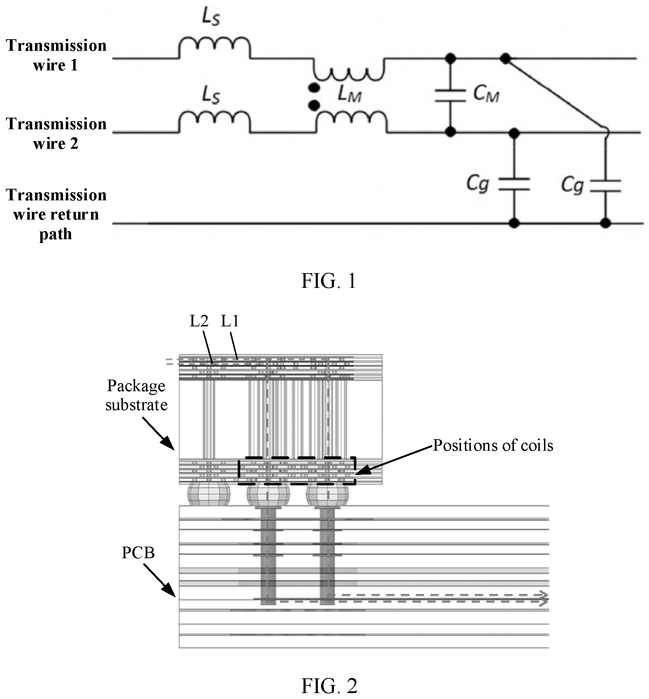

FIG. 1 is a differential equivalent circuit diagram of two lossless coupled transmission wires. As shown in FIG. 1, if a transmission wire 1 is used as an attack wire, a transmission wire 2 is used as a victim wire, and far-end crosstalk (FEXT) on the transmission wire 2 is as follows:

$$FEXT = k \bullet \left( \frac{C_M}{C_g + C_M} - \frac{L_M}{L_S} \right)$$

Herein, k is a constant, $L_s$ represents self-inductance of a single transmission wire per unit length, $L_M$ represents mutual inductance of two transmission wires per unit length, $C_M$ represents mutual capacitance of two transmission wires per unit length, and $C_g$ represents ground capacitance of a single transmission wire per unit length.

For a vertical (Z-direction) interconnection structure (for example, a TSV, a PTH, a solder ball, or a connector), the following relationship exists:

$$\frac{C_M}{C_M + C_g} - \frac{L_M}{L_S} < 0$$

Therefore, to alleviate a problem of far-end crosstalk (FEXT), there are two methods: (1) increasing mutual capacitance between two interconnection structures; and (2) reducing mutual inductance between the two interconnection structures. A mechanism of reducing the mutual inductance is adding additional reverse mutual inductance $L_{M'}$, inductance becomes $(L_M - L_{M'})$, thereby implementing mutual inductance elimination (or crosstalk elimination).

It may be understood herein that, in an electronic component, a signal transmission channel may include a transmission wire, a vertical interconnection structure connected to the transmission wire, and the like. The vertical interconnection structure may include a TSV, a PTH, a solder ball, a connection pad (or a connector), and the like. The vertical interconnection structure is also referred to as a vertical transition section, a Z-direction interconnection structure, or the like. In addition, "adjacent" in "adjacent single-ended signals", "adjacent transmission wires", and "adjacent transmission channels" in this application means that vertical interconnection structures in corresponding signal transmission channels are disposed adjacent to each other.

Embodiments of this application provide a new technical solution. Coils are added to vertical interconnection structures of adjacent transmission channels to form a multi-layer coupled inductor, that is, form inductive coupling (inductive couple), so that crosstalk between single-ended signals can be reduced.

The new technical solution provided in this application may be applied to a parallel port interconnection scenario with a single-ended signal, for example, DDR (double data rate, DDR), LPDDR (low power double data rate, LPDDR), or HBM (high bandwidth memory, HBM). However, this application is not limited thereto.

For example, embodiments of this application provide an electronic device. The electronic device may be an electronic product like a mobile phone, a tablet computer, a personal computer (personal computer, PC), a vehicle-mounted computer, a smartwatch, a smart band, or a server. A disposing form of the electronic device is not limited in this application. A first electronic component and a second electronic component that are interconnected are disposed in the electronic device. The first electronic component has a plurality of single-ended signal transmission channels (or conductive paths), and the first electronic component is electrically connected to the second electronic component through the plurality of transmission channels, to implement input and output (I/O) of a single-ended signal. Coils are disposed in vertical interconnection structures of adjacent signal transmission channels in the first electronic component, to form a multi-layer coupled inductor, so that mutual inductance between two adjacent vertical interconnection structures can be reduced, and crosstalk between adjacent single-ended signals can be reduced.

Certainly, based on an actual requirement, a coil may be additionally disposed in the second electronic component to form a multi-layer coupled inductor, to reduce crosstalk between adjacent single-ended signals in the second component.

The first electronic component may be any component that uses a single-ended signal, and may be set based on a requirement in practice. This is not limited in this application.

For example, in some possible implementations, the first electronic component may be a chip or a part of components in the chip.

For another example, in some possible implementations, the first electronic component may be a circuit board or a part of components in the circuit board. For example, the circuit board may be a printed circuit board (printed circuit board, PCB), a package substrate, an interposer (interposer), a carrier board on which a functional module is disposed, or the like.

For example, refer to FIG. 2. In some possible implementations, the first electronic component may be a package substrate, the second electronic component may be a PCB, and the package substrate is connected to the PCB through a solder ball (ball). The multi-layer coupled inductor added to the first electronic component may be disposed in a vertical interconnection structure shown by a dashed box in FIG. 2.

The following uses the package substrate as an example to describe a specific disposition of the multi-layer coupled inductor in the package substrate by using a specific embodiment.

Embodiment 1

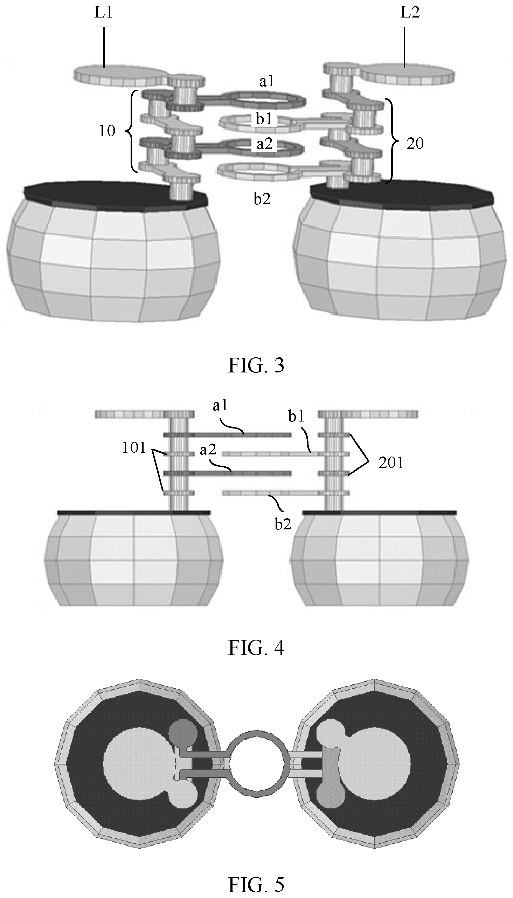

FIG. 3 is a three-dimensional diagram of a multi-layer coupled inductor in a package substrate according to an embodiment of this application, FIG. 4 is a side view of FIG. 3, and FIG. 5 is a top view of FIG. 3.

With reference to FIG. 2, FIG. 3, FIG. 4, and FIG. 5, Embodiment 1 provides a package substrate. The package substrate includes a first transmission wire L1, a second transmission wire L2, a first coil 10, and a second coil 20. The first coil 10 is coupled to the first transmission wire L1, and the second coil 20 is coupled to the second transmission wire L2.

For example, refer to FIG. 2 and FIG. 3. The first coil 10 and the second coil 20 are disposed in a vertical interconnection structure of the package substrate. One end of the first coil 10 may be connected to a solder ball (ball), and the other end may be connected to the first transmission wire L1 through a plated through hole PTH (plated through hole). Similarly, one end of the second coil 20 may be connected to a solder ball (ball), and the other end may be connected to the second transmission wire L2 through a plated through hole PTH (plated through hole).

Refer to FIG. 3. On this basis, the first coil 10 includes a plurality of turns of windings (a1 and a2) distributed at different layers, and the second coil 20 includes a plurality of turns of windings (b1 and b2) distributed at different layers. In FIG. 3, only an example in which the first coil 10 and the second coil 20 each include two turns of windings is used for description, but this is not limited thereto. In some other possible implementations, the first coil 10 includes two turns of windings, and only one turn of winding may be disposed in the second coil 20.

It may be understood that a plurality of routing layers may be disposed in the package substrate, and a dielectric layer is disposed between adjacent routing layers, to implement electrical insulation between the two adjacent routing layers by using the dielectric layer. In this application, the plurality of turns of windings (a1 and a2) in the first coil 10 may be distributed at a plurality of routing layers, a single turn of winding may be set to a non-enclosed structure with an opening, and two ends of the single turn of winding at the opening may be connected to an adjacent winding through a connection structure like a metal via.

Similarly, the plurality of turns of windings (b1 and b2) in the second coil 20 may also be distributed at a plurality of routing layers, and two adjacent turns of windings (b1 and b2) may be connected to an adjacent winding through a connection structure like a metal via.

Still refer to FIG. 3. On this basis, in a thickness direction of the package substrate, the plurality of turns of windings (a1 and a2) in the first coil 10 and the plurality of turns of windings (b1 and b2) in the second coil 20 are alternately disposed in sequence, so that inductive coupling (inductive couple) is generated between the first coil 10 and the second coil 20.

For example, as shown in FIG. 3, the winding a1 and the winding a2 in the first coil 10 and the winding b1 and the winding b2 in the second coil 20 may be disposed as a1, b1, a2, and b2 from top to bottom, so that inductive coupling (inductive couple) can be formed, that is, mutual inductance can be generated, between every two adjacent windings (a1 and b1, b1 and a2, and a2 and b2), to form a multi-layer coupled inductor.

In this way, flow directions of currents on the first coil 10 and the second coil 20 are set to be opposite, so that reverse inductive coupling (inductive couple) can be formed between the first coil 10 and the second coil 20, to reduce or eliminate mutual inductance between the first transmission wire L1 and the second transmission wire L2, and further reduce crosstalk between signals on the first transmission wire and the second transmission wire.

In addition, based on a multi-layer coupled inductor design in this application, crosstalk between signals is reduced in a mutual inductance manner. This is more conducive to a high-speed and high-bandwidth scenario.

Certainly, to ensure that clear mutual inductance can be generated between the two adjacent windings (a1 and b1, b1 and a2, and a2 and b2), a projection of the plurality of turns of windings (a1 and a2) in the first coil 10 and a projection of the plurality of turns of windings (b1 and b2) in the second coil 20 may be set to have at least a partial overlapping region. For example, in some embodiments, as shown in FIG. 3, the projection of the plurality of turns of windings (a1 and a2) in the first coil 10 may overlap the projection of the plurality of turns of windings (b1 and b2) in the second coil 20, so that mutual inductance and mutual capacitance are generated between two adjacent windings to a greater extent.

In addition, based on the multi-layer coupled inductor design in this application, when the projection of the plurality of turns of windings (a1 and a2) in the first coil 10 and the projection of the plurality of turns of windings (b1 and b2) in the second coil 20 have at least the partial overlapping region, on a basis that inductive coupling (inductive couple) can be generated between the two adjacent windings (a1 and b1, b1 and a2, and a2 and b2), capacitive coupling (capacitive couple) can be further generated, that is, mutual capacitance is generated between two adjacent coils, so that mutual capacitance between the first transmission wire L1 and the second transmission wire L2 can be increased, to further reduce the crosstalk between the signals on the first transmission wire and the second transmission wire.

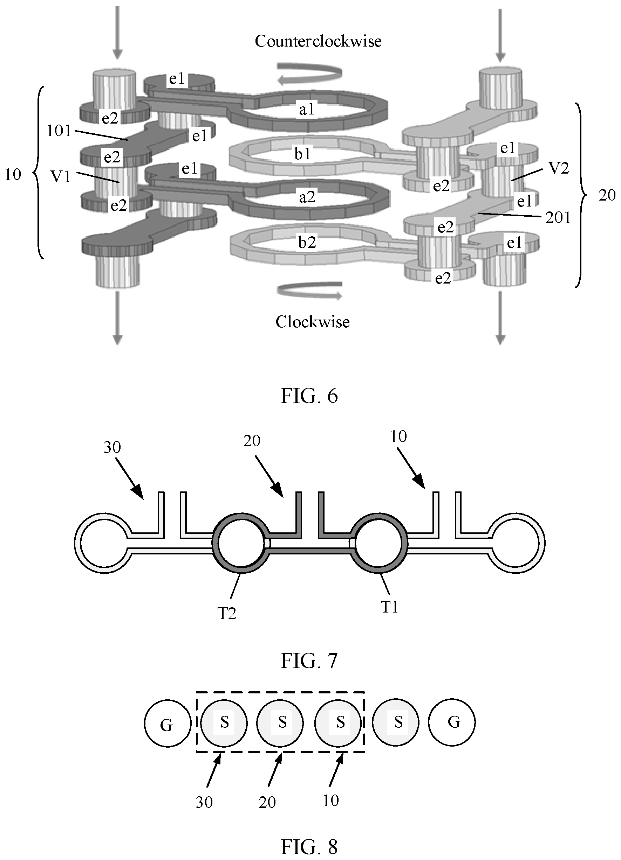

FIG. 6 is a diagram of a structure of a set of multi-layer mutual inductance coils (10 and 20) according to Embodiment 1. Arrows in FIG. 6 indicate current flow directions.

Refer to FIG. 6. To generate reverse inductance between the first coil 10 and the second coil 20, in some possible implementations, flow directions of currents on the plurality of turns of windings (a1 and a2) in the first coil 10 may be set to counterclockwise, and flow directions of currents on the plurality of turns of windings (b1 and b2) in the second coil 20 may be set to clockwise, to ensure that flow directions of currents on every two adjacent windings (a1 and b1, b1 and a2, and a2 and b2) are opposite, thereby ensuring that reverse inductive coupling is generated between any two adjacent windings.

Certainly, in some possible implementations, the flow directions of the currents on the plurality of turns of windings (a1 and a2) in the first coil 10 may alternatively be set to clockwise, and the flow directions of the currents on the plurality of turns of windings (b1 and b2) in the second coil 20 may alternatively be set to counterclockwise.

Still refer to FIG. 6. Two adjacent turns of windings (a1 and a2) in the first coil 10 are spaced by one turn of winding b1 in the second coil 20. In other words, another intermediate routing layer (including at least a routing layer at which the winding b1 is located) is disposed between a routing layer at which the winding a1 is located and a routing layer at which the winding a2 is located. In this case, to meet a connection between two adjacent turns of windings and ensure that flow directions of currents on the two turns of windings are consistent, a first connection portion 101 may be disposed at the intermediate routing layer. The first connection portion 101 is combined with a metal via V1 (which may also be referred to as a first metal via) to connect the winding a1 and the winding a2, to ensure that flow directions of currents on the winding a1 and the winding a2 are both counterclockwise (or clockwise). Similarly, a second connection portion 201 is disposed at an intermediate routing layer between two adjacent turns of windings (b1 and b2) in the second coil 20. The first connection portion 101 is combined with a metal via V2 (which may also be referred to as a second metal via) to connect the winding b1 and the winding b2, to ensure that flow directions of currents on the winding b1 and the winding b2 are both clockwise (or counterclockwise).

Certainly, based on a requirement, the first coil 10 may be provided with a plurality of first connection portions 101 and a plurality of metal vias V1, and the second coil 20 may be provided with a plurality of second connection portions 201 and a plurality of metal vias V2.

For example, for a disposition of the first connection portion 101, the first connection portion 101 connected between the winding a1 and the winding a2 is used as an example. Refer to FIG. 6. In some possible implementations, a first end e1 of the winding a1, a first end e1 of the winding a2, and a first end e1 of the first connection portion 101 may be aligned (in other words, projections overlap), and a second end e2 of the winding a1, a second end e2 of the winding a2, and a second end e2 of the first connection portion 101 are aligned. In this case, the first end e1 of the winding a1 may be connected to the first end e1 of the first connection portion 101 through the metal via V1, and the second end e2 of the first connection portion 101 is connected to the second end e2 of the winding a2 through the metal via V1, so that it can be ensured that flow directions of currents on the winding a1 and the winding a2 are consistent, and both are counterclockwise or clockwise.

The second end e2 of the winding a1 and the first end e1 of the winding a2 may be connected to another coil or another connection structure in the package substrate through a connection structure like the metal via V1 or the first connection portion 101 based on a requirement.

For a disposition of the second connection portion 201, the second connection portion 201 connected between the winding b1 and the winding b2 is used as an example. Refer to FIG. 6. In some possible implementations, a first end e1 of the winding b1, a first end e1 of the winding b2, and a first end e1 of the second connection portion 201 may be aligned vertically, and a second end e2 of the winding b1, a second end e2 of the winding b2, and a second end e2 of the second connection portion 201 are aligned vertically. In this case, the first end e1 of the winding b1 may be connected to the first end e1 of the second connection portion 201 through the metal via V2, and the second end e2 of the second connection portion 201 is connected to the second end e2 of the winding b2 through the metal via V2, so that it can be ensured that flow directions of currents on the winding b1 and the winding b2 are consistent, and both are clockwise or counterclockwise.

The second end e2 of the winding b1 and the second end e2 of the winding b2 may be connected to another coil or another connection structure in the package substrate through a connection structure like the metal via V2 or the second connection portion 201 based on a requirement.

Certainly, based on an actual requirement, windings (a1, a2, b1, and b2) may be connected to corresponding metal vias (V1 and V2) through a connection pad. Similarly, connection portions (101 and 201) may also be connected to the corresponding metal vias (V1 and V2) through a connection pad. However, this is not limited thereto.

In addition, to simplify a process, reduce manufacturing costs, and reduce a thickness of the package substrate, as shown in FIG. 4 and FIG. 6, a plurality of first connection portions 101 in the first coil 10 and the plurality of turns of windings (b1 and b2) in the second coil 20 may be disposed at a same routing layer. In other words, the first connection portion 101 and one winding in the second coil 20 are located at a same routing layer. Similarly, a plurality of connection portions 201 in the second coil 20 and the plurality of turns of windings (a1 and a2) in the first coil 10 may be disposed at a same routing layer. In other words, the second connection portion 102 and one winding in the first coil 10 are located at a same routing layer.

For example, refer to FIG. 3 and FIG. 6. The first connection portion 101 connected between the winding a1 and the winding a2 may be located at a same routing layer as the winding b2 disposed between the winding a1 and the winding a2. In other words, the first connection portion 101 and the winding b2 may be manufactured by using a same manufacturing process.

For another example, refer to FIG. 3 and FIG. 6. The second connection portion 201 connected between the winding b1 and the winding b2 may be located at a same routing layer as the winding a2 disposed between the winding b1 and the winding b2. In other words, the second connection portion 201 and the winding a2 may be manufactured by using a same manufacturing process.

It may be understood that, in comparison with a planar coupled inductor that occupies large space and causes a problem of an excessively large deployment area on the package substrate, in this application, the coils (10 and 20) are disposed at a plurality of routing layers to form the multi-layer coupled inductor, and the multi-layer coupled inductor has an advantage of occupying small space and is more conducive to component miniaturization. In addition, the multi-layer coupled inductor that occupies small space is used in this application, so that mutual inductive coupling between any two adjacent single-ended signals can be implemented.

It may be further understood that, there are usually a plurality of single-ended signal transmission channels in the package substrate, and a plurality of single-ended signal transmission channels may be disposed around one single-ended signal transmission channel. In other words, crosstalk may be generated between one single-ended signal and a plurality of (that is, two or more) single-ended signals. For example, crosstalk may be generated between one single-ended signal and two or three adjacent single-ended signals. In this case, in this application, the small-volume multi-layer coupled inductor design is used, so that flexible deployment can be implemented, and mutual inductive coupling between one single-ended signal and a plurality of adjacent single-ended signals can be implemented, thereby resolving a problem of crosstalk between a plurality of single-ended signals.

For example, the first coil 10 is located in the first transmission channel, and the second coil 20 is located in the second transmission channel. On a basis that the first transmission channel and the second transmission channel are disposed adjacent to each other, there may be a third transmission channel. The third transmission channel is disposed adjacent to the second transmission channel, and a third transmission wire and a vertical connection structure connected to the third transmission wire are disposed in the third transmission channel. In other words, the second transmission channel is disposed adjacent to both the first transmission channel and the third transmission channel.

To resolve crosstalk between single-ended signals in the second transmission channel and the third transmission channel, as shown in FIG. 7, a third coil 30 may be disposed in a vertical connection structure of the third transmission channel, and the third coil 30 is coupled to the third transmission wire.

Similar to the disposition of the first coil 10 and the second coil 20, the third coil 30 may use a multi-layer coupled inductor design. The third coil 30 includes a plurality of turns of windings distributed at different routing layers. In addition, in the thickness direction of the package substrate, the plurality of turns of windings in the third coil 30 and the plurality of turns of windings in the second coil 20 are alternately disposed in sequence, so that inductive coupling (inductive couple) and capacitive coupling (capacitive couple) can be formed between the third coil 30 and the second coil 20.

To ensure that large mutual inductance and mutual capacitance can be generated between the third coil 30 and the second coil 20, a projection of the plurality of turns of windings (a1 and a2) in the third coil 30 and the projection of the plurality of turns of windings in the second coil 20 may be set to have at least a partial overlapping region.

For example, refer to FIG. 7. Mutual inductance and mutual capacitance need to be generated between the second coil 20 and both the first coil 10 and the third coil 30. In this case, a single turn of winding in the second coil 20 may be disposed with two loop portions: a first loop portion T1 and a second loop portion T2. The first loop portion T1 is vertically aligned with a winding in the first coil 10 to generate mutual inductance and mutual capacitance, and the second loop portion T2 is vertically aligned with a winding in the third coil 30 to generate mutual inductance and mutual capacitance.

Certainly, one or more loop portions may be disposed in the first coil 10 and the third coil 30. This is not limited in this application, and may be set based on a requirement in practice.

For manners of disposing and connecting the plurality of turns of windings in the third coil 30, refer to related descriptions of the first coil 10 and the second coil 20. Details are not described herein again.

In addition, based on an actual requirement, connection structures (for example, solder balls, but not limited thereto) are disposed on an active surface of a component for a transmission channel, and may be deployed in different arrangement manners, for example, may be arranged in a straight-line shape, a Z shape, a fold-line shape, a regular hexagon shape, or the like. In the design in which the multi-layer coupled inductor is used in this application, different arrangement manners of the connection structures (single-ended signal transmission channels) can be implemented, and this is more applicable to mutual inductive coupling between a plurality of adjacent single-ended signals arranged in high density.

FIG. 8, FIG. 9, FIG. 11, and FIG. 13 respectively show four different solder ball (ball) arrangement manners, where G represents a solder ball in a ground signal transmission channel, and S represents a solder ball in a single-ended signal transmission channel.

For example, in some possible implementations, as shown in a dashed box in FIG. 8, three adjacent solder balls (S) are arranged in a straight line. In this case, as shown in FIG. 7, coils (10, 20, and 30) in corresponding three transmission channels may also be deployed in a straight-line direction.

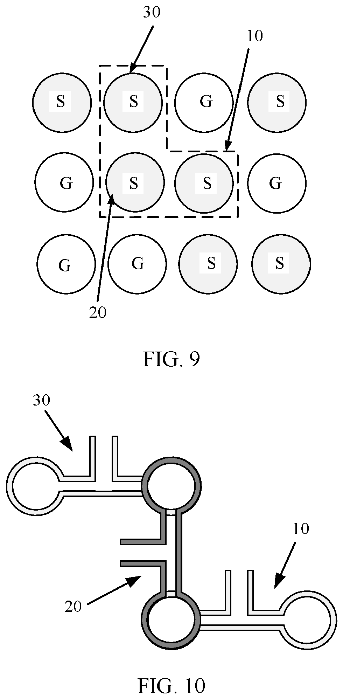

For example, in some possible implementations, as shown in a dashed box in FIG. 9, three adjacent solder balls (S) are arranged in a "Z" shape. In this case, as shown in FIG. 10, coils (10, 20, and 30) in corresponding three transmission channels may also be deployed in a "Z" shape.

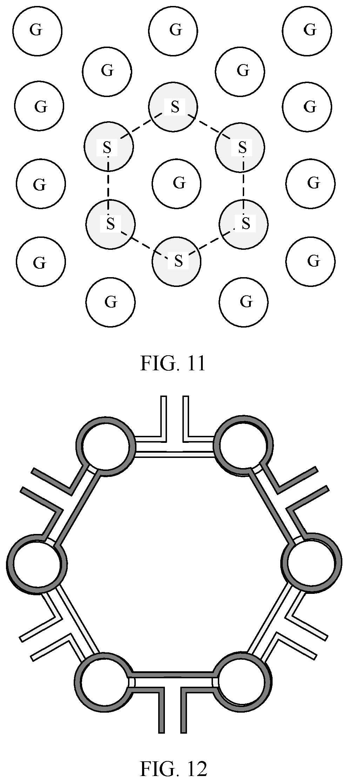

For example, in some possible implementations, as shown in FIG. 11 and FIG. 12, when a plurality of solder balls (S) are arranged in a regular hexagon shape, coils in corresponding six transmission channels may also be deployed in a regular hexagon shape.

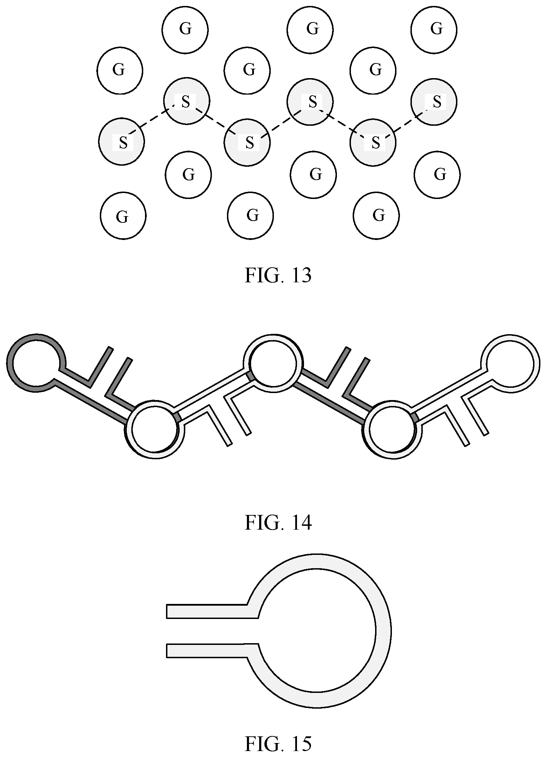

For example, in some possible implementations, as shown in FIG. 13 and FIG. 14, when a plurality of solder balls (S) are arranged in a fold-line shape, coils in a plurality of corresponding transmission channels may also be deployed in a fold-line shape.

In addition, for multi-layer coupled coils (10, 20, and 30) used in this application, a winding shape of the coil is not limited in this application, and may be set based on a requirement in practice.

For example, as shown in FIG. 15, in some possible implementations, a winding in a coil may be a circular structure with an opening.

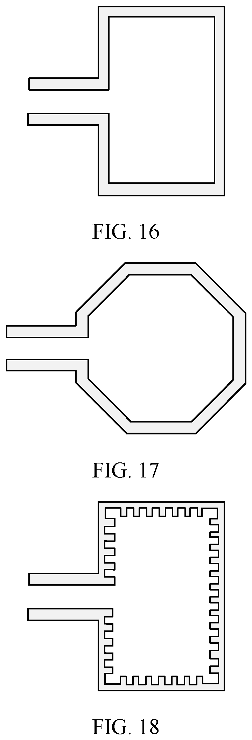

For another example, as shown in FIG. 16, in some possible implementations, a winding in a coil may be a rectangular structure with an opening.

For another example, as shown in FIG. 17, in some possible implementations, a winding in a coil may be an octagonal structure with an opening.

It is considered that a layer deviation of a circular winding is small during manufacturing, that is, the circular winding has good anti-layer deviation, in some possible implementations, a plurality of turns of windings in the coils (10, 20, and 30) may all use a circular winding structure.

Certainly, when one coil needs to be coupled to a plurality of coils, a single turn of winding in the coil may have a plurality of circular winding structures (refer to FIG. 7).

Refer to FIG. 18. On this basis, in some possible implementations, the plurality of turns of windings in the coils (10, 20, and 30) may be defected strip lines or defected microstrip lines (namely, defected microstrip structures, DMSs). This is not limited in this application, and may be set based on a requirement of a component in practice. A defect (or a slot) is disposed on a side edge of a winding, to introduce a slow wave structure (slow wave structure) into a coil, thereby reducing a layer deviation between the plurality of turns of windings and reducing space occupied by the coils (10, 20, and 30).

A shape of the defect disposed in the coil is not limited in this application, and may be a sawtooth shape, a comb tooth shape, or the like.

For example, as shown in FIG. 18, in some possible implementations, the plurality of turns of windings in the coils (10, 20, and 30) may be a comb-tooth-shaped strip line or microstrip line.

It should be noted that, in some possible implementations, all the plurality of turns of windings in the first coil 10, the second coil 20, and the third coil 30 may be a defected strip line or a defected microstrip line, but this is not limited thereto. In some other possible implementations, only a part of coils may be defected strip lines or defected microstrip lines. For example, one or two of the first coil 10, the second coil 20, and the third coil 30 may be defected strip lines or defected microstrip lines.

For a single coil, all windings in the coil may be defected strip lines or defected microstrip lines, or a part of windings in the coil may be defected strip lines or defected microstrip lines. This is not limited in this application.

In addition, the following compares, based on related detection parameters, a design in which the multi-layer coupled inductor is not used in the conventional technology with a design in which the multi-layer coupled inductor is used in this application.

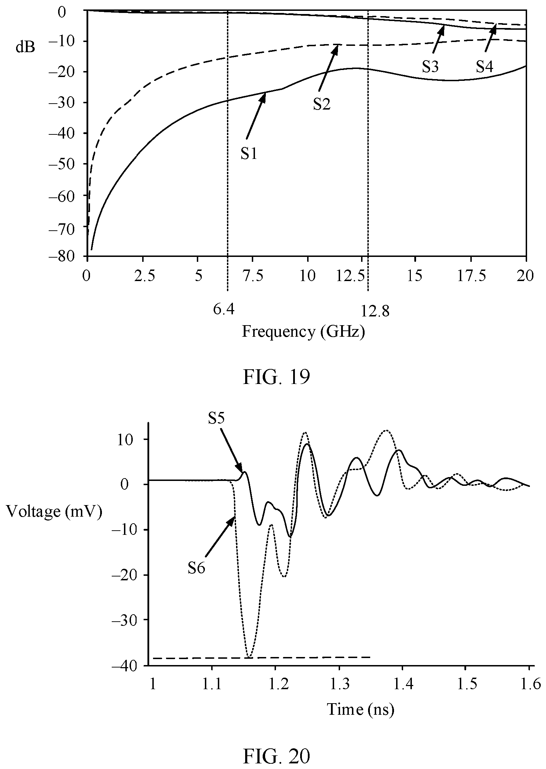

FIG. 19 shows crosstalk curves and insertion loss curves of an electronic component in this application and in the conventional technology. A curve S1 is a crosstalk curve in the design in which the multi-layer coupled inductor is used in this application; a curve S2 is a curve in the design in which the multi-layer coupled inductor is not used in the conventional technology; a curve S3 is an insertion loss curve in the design in which the multi-layer coupled inductor is used in this application; and a curve S4 is an insertion loss curve in the design in which the multi-layer coupled inductor is not used in the conventional technology.

By comparing curves S1 and S2 in FIG. 19, it can be learned from frequency domain that, crosstalk of the curve S1 at 6.4 GHz and 12.8 GHz is reduced by about 14 dB and 8 dB respectively compared with that of the curve S2; in other words, in the design in which the multi-layer coupled inductor is used in this application (S1), there is a crosstalk gain of about 14 dB at 6.4 GHz, and there is a crosstalk gain of about 8 dB at 12.8 GHz.

By comparing curves S3 and S4 in FIG. 19, it can be learned from frequency domain that, in the design in which the multi-layer coupled inductor is used in this application (S3), an insertion loss basically does not deteriorate below 15 Ghz. Therefore, this is more applicable to a high-bandwidth scenario.

FIG. 20 shows step response crosstalk curves of an electronic component in this application and in the conventional technology. A curve S5 is a step response crosstalk curve in the design in which the multi-layer coupled inductor is used in this application; a curve S6 is a step response crosstalk curve in the design in which the multi-layer coupled inductor is not used in the conventional technology.

Refer to FIG. 20. It can be learned from the curve S6 that time domain crosstalk of about 50.5 mV exists in the design in which the multi-layer coupled inductor is not used in the conventional technology. In contrast, it can be learned from the curve S5 that, in the design in which the multi-layer coupled inductor is used in this application, time domain crosstalk can be reduced to 20.8 mV, and a gain is 58.81%. In other words, in the design in which the multi-layer coupled inductor is used in this application, the time domain crosstalk can be greatly reduced.

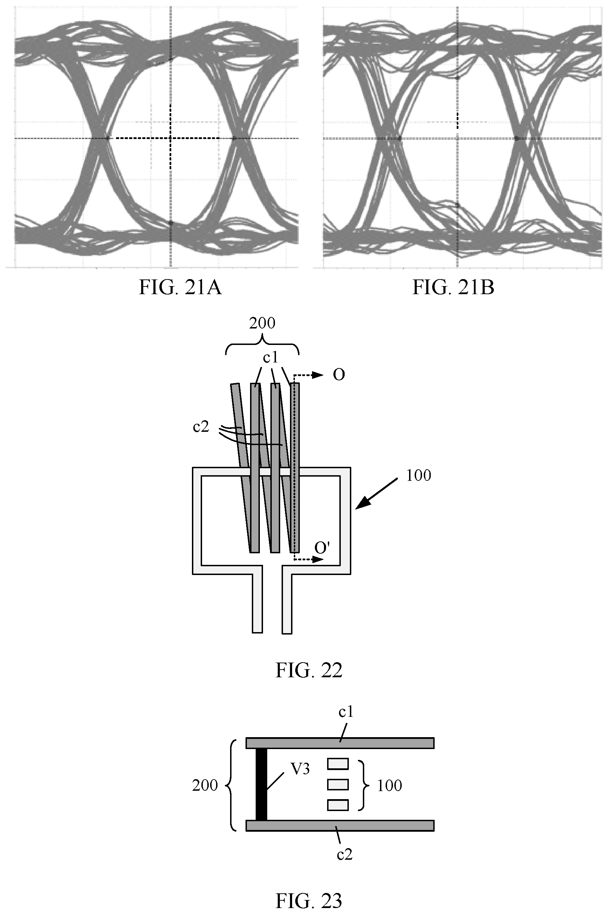

FIG. 21A is an eye diagram of the design in which the multi-layer coupled inductor is used in this application. In the eye diagram, a jitter is about 11.8 ps, and an eye height is about 283 mV. FIG. 21B is an eye diagram of the design in which the multi-layer coupled inductor is not used in the conventional technology. In the eye diagram, a jitter is about 16.4 ps, and an eye height is about 220 mV.

By comparing FIG. 21A and FIG. 21B, it can be learned that, in comparison with the design in which the multi-layer coupled inductor is not used in the conventional technology, in the design in which the multi-layer coupled inductor is used in this application, the eye height can be increased from 220 mV to 283 mV, the jitter can be reduced from 16.4 ps to 11.8 ps, and a gain is 22.26%. In other words, in the design in which the multi-layer coupled inductor is used in this application, the eye height can be increased and the jitter can be reduced. It should be understood herein that a smaller jitter is better, and a larger eye height is better.

Embodiment 2

Embodiment 2 provides a package substrate. A main difference between the package substrate and the package substrate in Embodiment 1 lies in that a manner of disposing a winding in a coil is different. In Embodiment 1, two coupled coils both have horizontal windings, that is, each turn of winding is wound at a routing layer. However, in Embodiment 2, in two coupled coils, one coil (a first coil) has at least one transverse winding at a routing layer, and the other coil (a second coil) has at least one vertical winding in a direction perpendicular to the routing layer.

The following describes a coil disposing manner in Embodiment 2.

FIG. 22 is a top view of coils in a package substrate according to Embodiment 2; and FIG. 23 is a cross-sectional view of FIG. 22 along OO' positions.

As shown in FIG. 12, Embodiment 2 provides a package substrate. The package substrate includes a first transmission wire, a second transmission wire, a first coil 100, and a second coil 200. The first coil 101 is coupled to the first transmission wire, and the second coil 200 is coupled to the second transmission wire. The first coil 100 may include one or more turns of transverse windings, and the second coil 200 may include one or more turns of vertical windings. The following embodiment is described by using an example in which the first coil 100 includes a plurality of turns of transverse windings and the second coil 200 includes a plurality of turns of vertical windings.

Dispositions of the first transmission wire and the second transmission wire in Embodiment 2 are basically consistent with those of the first transmission wire L1 and the second transmission wire L2 in Embodiment 1. For details, refer to the corresponding related descriptions in Embodiment 1. Details are not described herein again.

Similar to the disposition of the coils (10 and 20) in Embodiment 1, the first coil 100 and the second coil 200 may be distributed in a plurality of routing layers in the package substrate. For details, refer to the corresponding descriptions in Embodiment 1.

As shown in FIG. 12 and FIG. 13, the first coil 100 may include a plurality of turns of windings (or may be referred to as a plurality of turns of transverse windings) distributed at different layers. A disposition of the first coil 100 is basically consistent with that of the coils (10 and 20) in Embodiment 1. For example, for distribution and a connection manner of a plurality of turns of coils, refer to the related descriptions in Embodiment 1. Details are not described herein again.

A main difference from Embodiment 1 lies in that, in Embodiment 2, the plurality of turns of windings in the second coil 200 are vertical windings, and the plurality of turns of vertical windings are wound on the plurality of turns of transverse windings in the first coil 100. In this case, inductive coupling (inductive couple), namely, mutual inductance, can be generated between transverse inductance formed in the first coil 100 and vertical inductance formed in the second coil 200.

In this case, flow directions of currents on the first coil 100 and the second coil 200 are set, so that a flow direction of an induced current that is of the transverse inductance in the first coil 100 and that is on the second coil 200 can be opposite to a flow direction of a current on the second coil 200, and similarly, a flow direction of an induced current that is of the vertical inductance in the second coil 200 and that is on the first coil 100 is opposite to a flow direction of a current on the first coil 100. In this way, reverse inductive coupling (inductive couple) can be formed between the first coil 100 and the second coil 200, to reduce or eliminate mutual inductance between the first transmission wire and the second transmission wire, and further reduce crosstalk between signals on the transmission wires.

A manner of disposing the plurality of turns of vertical windings in the second coil 200 is not limited in this application, and the plurality of turns of vertical windings may be manufactured based on a requirement in practice.

For example, refer to FIG. 22 and FIG. 23. In some possible implementations, the second coil 200 may include a plurality of upper-layer wires c1, a plurality of lower-layer wires c2, and a plurality of metal vias V3. The plurality of upper-layer wires c1 may be disposed at a routing layer above the plurality of turns of transverse windings in the first coil 100, and the plurality of lower-layer wires c2 may be disposed at a routing layer below the plurality of turns of transverse windings in the first coil 100. On this basis, heads and tails of the plurality of upper-layer wires c1 and the plurality of lower-layer wires c2 are sequentially connected through the metal vias V3 to form a plurality of turns of vertical coils.

For example, refer to FIG. 22 and FIG. 23. The plurality of upper-layer wires c1 are sequentially a first upper-layer wire, a second upper-layer wire, and a third upper-layer wire from right to left, and the plurality of lower-layer wires c2 are sequentially a first lower-layer wire, a second lower-layer wire, and a third lower-layer wire from right to left. In this case, a lower end of the first upper-layer wire may be connected to a lower end of the first lower-layer wire through the metal via V3, an upper end of the first lower-layer wire may be connected to an upper end of the second upper-layer wire through the metal via V3, a lower end of the second upper-layer wire may be connected to a lower end of the second lower-layer wire through the metal via V3, an upper end of the second lower-layer wire may be connected to an upper end of the third upper-layer wire through the metal via V3, and a lower end of the third upper-layer wire may be connected to a lower end of the third lower-layer wire through the metal via V3.

Certainly, the upper-layer wire c1 and the lower-layer wire c2 may be directly connected through the metal via V3, or may be connected through the metal via V3 and another connection structure. This is not limited in this application, and may be set based on a requirement in practice.

To reduce and simplify a process, reduce manufacturing costs, and reduce a thickness of the package substrate, as shown in FIG. 22 and FIG. 23, in some possible implementations, in the second coil 200, the plurality of upper-layer wires c1 may be disposed at a same routing layer, and the plurality of lower-layer wires c2 may be disposed at a same routing layer. In other words, the plurality of upper-layer wires c1 are manufactured by using a same process, and the plurality of lower-layer wires c2 are manufactured by using a same process.

To reduce space occupied by the second coil 200, as shown in FIG. 22 and FIG. 23, in some possible implementations, the plurality of upper-layer wires c1 may be disposed in parallel, and the plurality of lower-layer wires c2 may be disposed in parallel.

Certainly, the package substrate may further include a third coil. A disposition of the third coil is similar to that of the second coil 200. The third coil may include one or more turns of vertical windings, and the plurality of turns of vertical windings may be wound on the first coil 100.

In addition, in Embodiment 2, windings in the first coil 100 and the second coil 200 may be defected strip lines or defected microstrip lines. For details, refer to the corresponding descriptions in Embodiment 1.

For other dispositions and related descriptions of Embodiment 2, refer to Embodiment 1 correspondingly. Details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. An electronic component, comprising a first transmission wire, a second transmission wire, a first coil, and a second coil, wherein

the first coil is coupled to the first transmission wire, and the second coil is coupled to the second transmission wire;
the first coil comprises a plurality of turns of windings distributed at different layers, and the second coil comprises at least one turn of winding; and
the plurality of turns of windings in the first coil and the at least one turn of winding in the second coil are alternately disposed in a thickness direction of the electronic component and are inductively coupled (inductive couple) to each other.

2. The electronic component according to claim 1, wherein
the first coil is reversely inductively coupled to the second coil.

3. The electronic component according to claim 1 or 2, wherein
a projection of the plurality of turns of windings in the first coil at least partially overlaps a projection of the at least one turn of winding in the second coil.

4. The electronic component according to any one of claims 1 to 3, wherein

the electronic component comprises a plurality of routing layers and a dielectric layer disposed between two adjacent routing layers; and
the plurality of turns of windings in the first coil and the at least one turn of winding in the second coil are distributed at the plurality of routing layers.

5. The electronic component according to any one of claims 1 to 4, wherein
the first coil comprises two turns of windings distributed at different layers, and the second coil comprises one turn of winding.

6. The electronic component according to any one of claims 1 to 4, wherein
the first coil comprises two turns of windings distributed at different layers, and the second coil comprises two turns of windings distributed at different layers.

7. The electronic component according to any one of claims 1 to 6, wherein

the first coil further comprises a plurality of first metal vias; and
two adjacent turns of windings in the first coil are connected through at least one first metal via.

8. The electronic component according to claim 7, wherein

the first coil further comprises a plurality of first connection portions; and
one first connection portion is disposed between two adjacent turns of windings in the first coil, and the two adjacent turns of windings in the first coil each are connected to two ends of the first connection portion through different first metal vias.

9. The electronic component according to claim 8, wherein
the first connection portion and one turn of winding in the second coil are distributed at a same layer.

10. The electronic component according to any one of claims 1 to 4 and 6 to 9, wherein

the second coil further comprises a plurality of second metal vias; and
two adjacent turns of windings in the second coil are connected through at least one second metal via.

11. The electronic component according to claim 10, wherein

the second coil further comprises a plurality of second connection portions; and
one second connection portion is disposed between two adjacent turns of windings in the second coil, and the two adjacent turns of windings in the second coil each are connected to two ends of the second connection portion through different second metal vias.

12. The electronic component according to claim 11, wherein
the second connection portion and one turn of winding in the first coil are distributed at a same layer.

13. The electronic component according to any one of claims 1 to 12, wherein
a transmission signal on the first transmission wire and a transmission signal on the second transmission wire are single-ended signals.

14. The electronic component according to any one of claims 1 to 13, wherein

the plurality of turns of windings in the first coil are defected strip lines or defected microstrip lines; and/or
the at least one turn of winding in the second coil is a defected strip line or a defected microstrip line.

15. The electronic component according to any one of claims 1 to 14, wherein

the electronic component further comprises a third transmission wire and a third coil, wherein the third coil is coupled to the third transmission wire;
the third coil comprises a plurality of turns of windings distributed at different layers; and
the plurality of turns of windings in the third coil and the at least one turn of winding in the second coil are alternately disposed in the thickness direction of the electronic component and are inductively coupled (inductively couple) to each other.

16. The electronic component according to claim 15, wherein
a projection of the plurality of turns of windings in the third coil at least partially overlaps the projection of the at least one turn of winding in the second coil.

17. The electronic component according to claim 15 or 16, wherein

a plurality of connection structures are disposed on an active surface of the electronic component, and the plurality of connection structures comprise a first connection structure, a second connection structure, and a third connection structure;
the second connection structure is disposed adjacent to both the first connection structure and the third connection structure; and
the first transmission wire is connected to the first connection structure through the first coil, the second transmission wire is connected to the second connection structure through the second coil, and the third transmission wire is connected to the third connection structure through the third coil.

18. The electronic component according to claim 17, wherein

the first connection structure, the second connection structure, and the third connection structure are arranged in a straight-line shape; or
the first connection structure, the second connection structure, and the third connection structure are arranged in a Z shape; or
the first connection structure, the second connection structure, and the third connection structure are arranged in a fold-line shape.

19. An electronic component, comprising a first transmission wire, a second transmission wire, a first coil, and a second coil, wherein

the first coil is coupled to the first transmission wire, and the second coil is coupled to the second output wire;
the first coil comprises at least one turn of transverse coil; and
the second coil comprises at least one turn of vertical coil, and the at least one turn of vertical coil is wound around the at least one turn of transverse coil.

20. The electronic component according to claim 19, wherein
the first coil is reversely inductively coupled to the second coil.

21. The electronic component according to claim 19 or 20, wherein
the first coil comprises a plurality of turns of transverse coils distributed at different layers, and the second coil comprises a plurality of turns of vertical coils.

22. The electronic component according to any one of claims 19 to 21, wherein

the second coil comprises a plurality of upper-layer wires, a plurality of lower-layer wires, and a plurality of first metal vias;
the plurality of upper-layer wires are disposed above the first coil, and the plurality of lower-layer wires are disposed below the first coil; and
heads and tails of the plurality of upper-layer wires and the plurality of lower-layer wires are sequentially connected through the plurality of first metal vias to form the plurality of turns of vertical coils.

23. The electronic component according to claim 22, wherein

the electronic component comprises a plurality of routing layers and a dielectric layer disposed between two adjacent routing layers; and
the plurality of upper-layer wires, the plurality of lower-layer wires, and the transverse coils are distributed at the plurality of routing layers.

24. The electronic component according to claim 22 or 23, wherein
the plurality of upper-layer wires are located at a same layer, and the plurality of lower-layer wires are located at a same layer.

25. The electronic component according to any one of claims 22 to 24, wherein
the plurality of upper-layer wires are disposed in parallel, and the plurality of lower-layer wires are disposed in parallel.

26. The electronic component according to any one of claims 21 to 25, wherein

the first coil further comprises a plurality of second metal vias; and
two adjacent turns of windings in the first coil are connected through at least one second metal via.

27. The electronic component according to claim 26, wherein

the first coil further comprises a plurality of connection portions; and
one connection portion is disposed between two adjacent turns of windings in the first coil, and the two adjacent turns of windings each are connected to two ends of the connection portion through different first metal vias.

28. A circuit board, comprising the electronic component according to any one of claims 1 to 27.

29. A chip, comprising the electronic component according to any one of claims 1 to 27.

30. An electronic device, comprising a first electronic component and a second electronic component that are interconnected, wherein the first electronic component is the electronic component according to any one of claims 1 to 27; and
the second electronic component is electrically connected to the first transmission wire and the second transmission wire in the first electronic component.

FIG. 1

FIG. 2

FIG. 3

FIG. 4

FIG. 5

Counterclockwise

Clockwise

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

FIG. 20

FIG. 21A

FIG. 21B

FIG. 22

FIG. 23

## INTERNATIONAL SEARCH REPORT

| International application No. |
|---|
| **PCT/CN2023/121129** |

| A. | CLASSIFICATION OF SUBJECT MATTER |
|---|---|

H01F27/28(2006.01)i;  H01L23/64(2006.01)i

According to International Patent Classification (IPC) or to both national classification and IPC

| B. | FIELDS SEARCHED |
|---|---|

Minimum documentation searched (classification system followed by classification symbols)

IPC: H01F, H01L

Documentation searched other than minimum documentation to the extent that such documents are included in the fields searched

Electronic data base consulted during the international search (name of data base and, where practicable, search terms used)

CNTXT, ENTXT, ENTXTC, DWPI, CNKI: 线圈, 绕组, 感性耦合, 交替, 横向, 竖向, 单端信号, coil, winding, inductive couple, alternate, horizontal, vertical, single ended signal

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 115276585 A (HUAWEI TECHNOLOGIES CO., LTD.) 01 November 2022 (2022-11-01) description, paragraphs 59-141, and figures 1-17 | 1-18, 28-30 |
| A | CN 115699452 A (HUAWEI TECHNOLOGIES CO., LTD.) 03 February 2023 (2023-02-03) entire document | 1-30 |
| A | CN 113131166 A (TSINGHUA UNIVERSITY et al.) 16 July 2021 (2021-07-16) entire document | 1-30 |
| A | JP 2002110426 A (TOSHIBA CORP.) 12 April 2002 (2002-04-12) entire document | 1-30 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **04 June 2024** | **06 June 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/121129**

| Patent document cited in search report | | | Publication date (day/month/year) | Patent family member(s) | | | Publication date (day/month/year) |
|---|---|---|---|---|---|---|---|
| CN | 115276585 | A | 01 November 2022 | None | | | |
| CN | 115699452 | A | 03 February 2023 | WO | 2021253290 | A1 | 23 December 2021 |
| CN | 113131166 | A | 16 July 2021 | CN | 113131166 | B | 03 May 2022 |
| JP | 2002110426 | A | 12 April 2002 | None | | | |

Form PCT/ISA/210 (patent family annex) (July 2022)